# EUROPEAN PATENT SPECIFICATION

(11) **EP 1 519 101 B1**
(45) Date of publication and mention of the grant of the patent: **03.12.2014**
(21) Application number: 04022387.7
(22) Date of filing: 21.09.2004
(51) Int. Cl.: F17C 13/04, C23C 16/44, B08B 9/00

(54) **Purgeable container**
Spülbarer Behälter
Réservoir purgeable

(30) Priority: 24.09.2003 US 669942
(43) Date of publication of application: 30.03.2005
(73) Proprietor: AIR PRODUCTS AND CHEMICALS, INC., Allentown, PA 18195-1501 (US)
(72) Inventor: Steidl, Thomas Andrew, Escondido, CA 92025 (US); Vivanco, Gildardo, San Diego, CA 92109 (US); Birtcher, Charles Michael, Valley Center, CA 92082 (US)
(74) Representative: Marx, Lothar

(56) References cited:
- EP-A- 1 365 041
- EP-A2- 1 327 603
- US-B1- 6 431 229

## Description

### BACKGROUND OF THE INVENTION

The present invention relates to a detachable container of a chemical delivery system for delivering high-purity or ultra-high purity chemicals to a use point, such as a semiconductor fabrication facility or tool(s) for chemical deposition. Although the invention may have other applications, it is particularly applicable in semiconductor fabrication.

Semiconductor manufacturers require chemicals having at least a high-purity for production processes to avoid defects in the fabrication of semiconductor devices. The chemicals used in the fabrication of integrated circuits usually must have an ultra-high purity to allow satisfactory process yields. As integrated circuits have decreased in size, there has been an increase in the need to maintain the purity of source chemicals.

One ultra-high purity chemical used in the fabrication of integrated circuits is tetrakis(dimethylamido)titanium (TDMAT). TDMAT is used widely in integrated circuit manufacturing operations, such as chemical vapor deposition (CVD) to form titanium and titanium nitride films, vias and barrier layers.

Integrated circuit fabricators typically require TDMAT with 99.99+% purity, preferably 99.999999+%(8-9's+%) purity. This high degree of purity is necessary to maintain satisfactory process yields. It also necessitates the use of special equipment to contain and deliver the high-purity or ultra-high purity TDMAT to CVD reaction chambers.

High-purity chemicals and ultra-high purity chemicals, such as TDMAT, are delivered from a bulk chemical delivery system to a use point, such as a semiconductor fabrication facility or tool(s). A delivery system for high-purity chemicals is disclosed in U.S. Pat. No. 5,590,695 (Seigele, et al.) which uses two block valve assemblies 76 and 91, but not to facilitate rapid clean disconnection. (Related patents include U.S. Pat. Nos. 5,465,766; 5,562,132; 5,607,002; 5,711,354; 5,878,793 and 5,964,254.) The system comprises: a block valve assembly housing a low pressure vent valve and a carrier gas isolation valve, while the other block valve assembly houses a container bypass valve and a process isolation canister bypass valve. The block valve assemblies are not in series nor are they used for disconnect of a container from a manifold.

Solvent purging systems for removal of low vapor pressure chemicals from process conduits are disclosed in US5,964,230 and US6;138,691. Such systems may add additional complexity to purging and increase the amount of materials which must be disposed of.

Low dead space couplings are known, such as US6,161,875.

TDMAT is considered a low vapor pressure, high purity chemical by the semiconductor industry, and thus presents special problems when breaking a process line or changing out a process container where the line must be cleaned prior to such detachment. Significant time delays in cleaning down a line or conduit are a disadvantage in the throughput of a wafer processing facility, where expensive tools and large batch processing of expensive wafers, each containing hundreds of integrated circuits require fast processing and avoidance of significant or lengthy offline time for cleaning or changeout of process containers or vessels.

The Present Invention is more specifically directed to the field of process chemical delivery in the electronics industry and other applications requiring low vapor pressure, high purity chemical delivery. More specifically, the present invention is directed to apparatus for the cleaning of process chemical delivery lines, containers and associated apparatus, particularly during changeout of process chemical or process chemical containers in such process chemical delivery lines, quickly and thoroughly, when processing with low vapor pressure, high purity chemicals.

Evacuation and gas purge of process chemical lines have been used to remove residual chemicals from delivery lines. Both vacuum draw and inert gas purge are successful in quickly removing high volatility chemicals, but are not effective with low volatility chemicals. Safety is a problem when extracting highly toxic materials.

Use of solvents to remove residual chemicals has been suggested to remove low vapor pressure chemicals from process lines when the lines need to be disconnected such as for replacement of a vessel or container for either refill or maintenance. However, solvent systems can be complex and require a source of solvent and a means to handle the contaminated solvent after it has been used for its cleaning function.

Additional patents directed to effective chemical removal are US 6,345,642 and US 6,418,960.

Furthermore EP 1 365 041 A1 discloses a purgeable manifold comprising a readily cleanable and purgeable manifold for dispensing or delivering a low vapour-pressure, high-purity chemical to or from a process container, said manifold comprising several valves and conduits. Said valves and conduits can have flow communication with each other and with sources of vent, push gas and purge gas in such a way that it is possible to quickly and easily flush the manifold, for example if the manifold has to be replaced. From US 6,431,229 B1 a solventless purgeable diaphragm valved manifold for low vapour-pressure chemicals is known. EP 1 327 603 A2 describes a cabinet for chemical delivery with solvent purge.

The present invention overcomes the drawbacks of the prior art in purging and cleaning chemical process lines for low vapor pressure chemicals without the requirements of lengthy purge cycles of pressurized gas and vacuum, as will be more fully set forth below.

### BRIEF SUMMARY OF THE INVENTION

The present invention is a container having two ports; first block valve having two diaphragm valves, each valve having a valve seat side and a diaphragm side, each valve seat side faces the other valve seat side, and connected to the first end of a dispense conduit, one diaphragm side connected to a first port, and another diaphragm side connected to vent or vacuum.

### BRIEF DESCRIPTION OF SEVERAL VIEWS OF THE DRAWINGS

FIG 1A is a schematic of an embodiment of the present invention having a block diaphragm valve assembly on one port of a container.

FIG 2A is a partial cross-section of a block valve assembly with two diaphragm valves as used in the embodiment of the present invention.

FIG 2B is an isometric exploded view of the block diaphragm valve assembly of FIG 2A showing the diaphragm and the pneumatic actuator removed from the block.

FIG 3 is a partial cross-section view of the low dead space connector used in the first conduit of the present invention.

### DETAILED DESCRIPTION OF THE INVENTION

The present invention provides a readily cleanable and purgeable container for dispensing or delivery of low vapor pressure, high purity chemical to a manifold or chemical delivery system, which in turn dispenses the chemical to a process tool or reactor for consumption. The apparatus of the present invention is particularly suited for process chemicals used in the semiconductor industry.

Although the apparatus of the present invention is applicable to low vapor pressure chemicals, such as tetrakis(dimethylamido)titanium, it is also applicable to chemicals which do not have a low vapor pressure, i.e., high vapor pressure chemicals, and thus can be used with a wide array of chemicals.

The container and its related chemical delivery system of the present invention may be used in various applications with various fluids, but has particular application for liquid chemicals that have at least a high purity. For example, the liquid chemical may be selected from the group consisting of tetraethylorthosilicate (TEOS), borazine, aluminum trisec-butoxide, carbon tetrachloride, trichloroethanes, chloroform, trimethylphosphite, dichloroethylenes, trimethylborate, dichloromethane, titanium n-butoxide, diethylsilane, hexafluoroacetylacetonato-copper(1)trimethyivinylsilane, isopropoxide, triethylphoshate, silicon tetrachloride, tantalum ethoxide, tetrakis(diethylamido)titanium (TDEAT), tetrakis(dimethylamido)titanium (TDMAT), bis-tertiarybutylamido silane, triethylborate, titanium tetrachloride, trimethylphosphate, trimethylorthosilicate, titanium ethoxide, tetramethyl-cyclo-tetrasiloxane, titanium n-propoxide, tris(trimethylsiloxy)boron, titanium isobutoxide, tris(trimethylsilyl)phosphate, 1,1,1,5,5,5-hexafluoro-2,4-pentanedione, tetramethylsilane and mixtures thereof.

The purgeable container for a chemical delivery system of the present invention will now be described with regard to a particular embodiment processing TDMAT as the low vapor pressure, high purity chemical delivered from the process container for transport to a process tool of a semiconductor fab.

In a bubbler, the liquid chemical is entrained in a pressurized gas, bubbler gas or carrier gas that is bubbled into the liquid chemical, as it resides in th e process container, through a diptube which introduces the pressurized gas into the liquid chemical below the surface of the chemical. The pressurized gas entrains or vaporizes some of the chemical and the vapor leaves with the pressurized gas through an outlet communicating with the process tool.

Chemical delivery can also be accomplished by vapor draw, where a vacuum is applied to the outlet of the process container to induce the chemical to vaporize and leave via the outlet under vacuum conditions. This vapor draw can be accomplished with or without positive gas pressure assist from push gas directed into the process container from the inlet.

It is also possible to use the present invention in a liquid delivery to the process tool where the process container delivers liquid chemical out a diptube to the process tool by the action of pressurization gas or push gas on the headspace or liquid surface of the chemical in the process vessel (direct liquid injection or DLI).

Pressurizing gas can be any inert gas, such as nitrogen, argon, helium or the rare noble gases.

Purge gas is used to clean process conduits or lines when such conduits are off-line and subject to cleaning or removal of residual chemical.

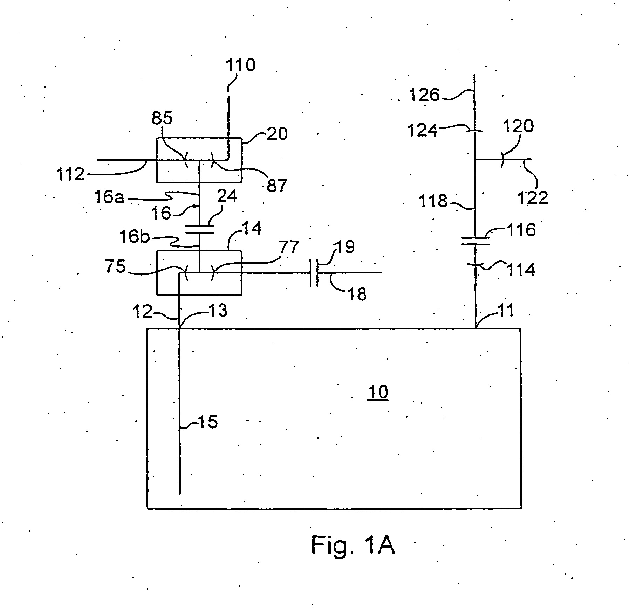

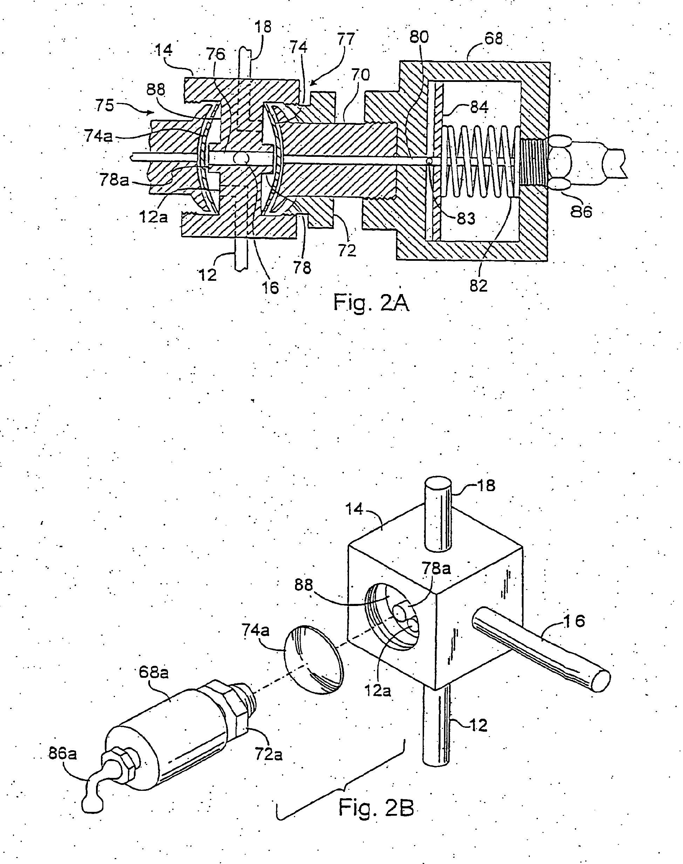

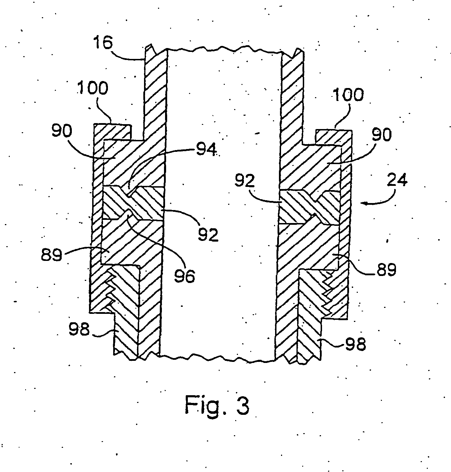

With reference to FIG 1A, a high purity chemical delivery system is illustrated wherein a first container 10 is outfitted with a first port 13 and a second port 11 to contain a low vapor pressure, high purity chemical, such as TDMAT, used in electronic device fabrication. The chemical can be removed from the container 10 via a diptube 15, through port 13, conduit 12 and into first block diaphragm valve assembly 14 containing two opposing diaphragm valves, first diaphragm valve 75 and second diaphragm valve 77, having their valve seat sides or low dead space sides facing one another to facilitate quick and thorough cleanout, as will be outlined in detail below with reference to FIGs 2 and 3.

Valve seat sides of valves 75 and 77 have flow communication with a short, low dead space first conduit 16 having a first end 16b adjacent assembly 14 and a second end 16a adjacent a second block diaphragm valve assembly 20. Valve 75 provides flow communication for the low vapor pressure, high purity chemical from container 10, while valve 77 provides access to vent or vacuum for the wetted surface areas of first conduit 16 and the adjacent areas in first and second block diaphragm valve assemblies 14 and 20.

The first end 16b and the second end 16a of conduit 16 are separated by a low dead space connector 24 described in greater detail in reference to FIG 3.

Second block diaphragm valve assembly 20 also has two opposing diaphragm valves, third diaphragm valve 85 and fourth diaphragm valve 87, which also have their valve seat sides or low dead space sides facing one another to facilitate quick and thorough cleanout, as will be outlined in detail below with reference to FIGs 2 and 3. Valve 85 controls access to purge gas and or push gas to the wetted surface area of the first conduit 16 and the passages of the block diaphragm valve assemblies 14 and 20, and particularly, the valve seat sides of such valves offering the least dead space. Valve 87 controls delivery of chemical from container 10 to downstream dispense 110 of low vapor pressure, high purity chemical or alternatively carrier gas in a bubbling application.

Second port 11 of first container 10 is controlled by second valve means, such as valve 114, which in turn provides access to vacuum/vent, and or push gas through third conduit 118. Conduit 118 has a low dead space connector 116, which can be structured similar to the connection illustrated in FIG 3, but it does not have to have that structure, because generally conduit 18 and 118 do not become exposed to low vapor pressure, high purity chemical in the normal operation as a liquid out container 10. Conduit 118 can be supplied with helium push gas or other non reactive or inert push gas through valve 124 and source of push gas 126. Push gas passes through open valve 124, conduit 118, connector 116, open valve 114, port 11 and into container 10 to pressurize the headspace above the contained low vapor pressure, high purity chemical, to dispense the chemical preferably in the liquid phase out diptube 15.

When container 10 needs replacement for refill or maintenance, valve 124 is closed, shutting off push gas, and vacuum from source 122 is introduced through open valve 120 into conduit 118 and passes through valve 114 ( or up to valve 114 in a cycle purge sequence) .

To take container 10 off line, it is necessary to break the connections at low dead space connectors 24, 19, and 116. Connector 116 and 19 does not represent a problem, because typically, it has only been exposed to push gas or purge gas. However, connector 24 and line 16 present problems, because these wetted surfaces have been exposed to low vapor pressure, high purity chemical, such as TDMAT, which is adversely effected by atmospheric exposure and represents an operator risk, if TDMAT is allowed out into the ambient of the opened conduit 16.

Therefore, the wetted surfaces in conduit 16, between the diaphragm valves of block diaphragm valve assemblies 14 and 20, are minimized to create low dead space and to facilitate quick and thorough chemical removal, by the repetitious exposure of the wetted surfaces to vacuum and or vent through source 18 and purge gas, vent, or vacuum from conduit 112. These may be conducted alternately until vacuum is rapidly achieved in a short time interval, demonstrating thorough removal of low vapor pressure, high purity chemical from the wetted surface area. This allows opening of connector 24, along with connector 116 and 19 to take container 10 out of service for any reason. This structure has allowed clean out and purging of lines of low vapor pressure, high purity. chemical in a fraction of the time historically required by the industry to accomplish the same goal. This allows faster service or replenishment with less down time and more online time for electronic fabricators using this type of equipment in comparison to historic equipment.

An important aspect to the efficient clean out and purging of the man ifold of the present invention is to minimize wetted surface area and to simplify the valve surfaces, where chemical could be hung up during clean out and purging. The use of low dead space connectors 24, tandem sets of block diaphragm valve assemblies 14 and 20 and the opposing valve seat sides of diaphragm valves in the block valve assemblies, collectively allow the minimization of wetted surfaces and the avoidance of complex wetted surface areas susceptible to capture or retention of low vapor pressure, high purity chemical. This allows for quick cleanout, disconnect and reinstallation without loss of expensive chemical, without reaction of such chemical with atmospheric contaminants, without exposure of operators to reactive or toxic chemicals or their byproducts, without contamination of the wetted surface lines when the equipment is brought back online and avoids corrosion of the equipment by atmospheric contaminants or the reaction products of atmospheric contaminants and the chemical.

FIG 2A shows greater detail of first block diaphragm valve assembly 14, which is the same valve structure as second block diaphragm valve assembly 20 (which is not shown separately in detail for that reason). FIG 2A is a partial cross-section of first block diaphragm valve assembly 14 showing liquid low vapor pressure, high purity chemical or second conduit 12 in flow communication with first diaphragm valve 75 comprising diaphragm 74a comprising a flexible metal disk with a convex side and a concave side comprising the valve seat side of the valve and valve seat 78a, as well as an actuator similar to that shown for valve 77. Conduit 12 communicates with valve 75 through aperture 12a. The diaphragm side of the diaphragm comprises the cross-sectional triangular area between the concave surface of the diaphragm 74a, the floor of core 88 and the surface of valve seat 78a in the closed condition. Valve seat 78a en gages the concave side of the diaphragm 74a and allows liquid low vapor pressure, high purity TDMAT to pass through the valve when the diaphragm disengages the valve seat 78a, to the short channel 76 to conduit 16 which connects with the second block valve assembly 20 and ultimately the dispense of chemical at dispense point 110. Diaphragm 74a is actuated by any means, such as manual actuator, electric solenoid, hydraulic pressure actuation or preferably as illustrated, a pneumatic actuator, illustrated for the other diaphragm valve of block diaphragm valve assembly 14.

Vacuum/vent are provided to first conduit 16 by way of conduit 18 and a second diaphragm valve 77 comprising diaphragm 74, valve seat 78, actuator connector 70, actuator armature 80, pneumatic actuator 68, bias spring 82, bellows or piston 84, which translates pneumatic pressure to valve actuation through armature 80 and pneumatic source 86. Pneumatic gas is supplied to bellows 84 by source 86 and a coaxial channel in armature 80 which communicates with bellows 84 through aperture 83. Pneumatic actuator is engaged to the diaphragm by locking nut 72. Second diaphragm valve 77 has a diaphragm side of its diaphragm 74 and a valve seat side, just as diaphragm valve 75. Valve 75 has a similar actuator structure as illustrated for valve 77.

The valve seat side of the diaphragm valves of the present invention have very little dead space or volume where a low vapor pressure liquid chemical can be retained. In addition, diaphragm valves 75 and 77 are juxtaposed to one another at their valve seat sides and connect to the conduit 16 via the very short channel 76 bored out of the monoblock of the block diaphragm valve assembly 14 base. Due to this advantageous arrangement of these two valves, it is possible to clean first conduit 16 by application of sequenced pressurizing gas and vacuum, without the need for additional means, such as solvents. Cleanout can be accomplished in a short interval, such as several minutes of sequenced pressurized gas and vacuum, in contrast to prior art systems which take several hours to several days to reach the prescribed level of residual chemical in the conduits prior to detachment of the conduits for maintenance or changeout of the container 10.

The valve seat side of the diaphragm valves comprises that portion of the valve in direct communication with the common conduit, such as 16, by way of the short channel, such as 76, and up to the sealing surface of the valve seat with the concave surface of the diaphragm when the valve is closed. The diaphragm side of the diaphragm valves comprises the other side of the sealing surface of the valve seat in communication with the aperture, such as 12a, and still under the concave side of the diaphragm. The diaphragm side of the diaphragm valve can be seen to constitute an annular, generally V-shaped cross-sectional space, which can potentially become wetted with chemical and constitute a difficult area to effectively and quickly clean of such chemical. Therefore, the present invention, by having the common conduit or first conduit 16 communicate directly with the valve seat side of the diaphragm valves of the first block valve assembly and by having the diaphragm valves juxtaposed to one another through a very short connection or channel 76, affords a low dead space valve arrangement, which can be readily cleaned by application of sequenced, repeated pressurized gas and vacuum, without the use of solvent.

The pneumatic actuator 68 has a source 86 of pressurized air for valve actuation. The valve 77 is a normally closed valve which is biased to the closed position by spring 82 operating on baffle 84 and actuator armature 80 which pushes against diaphragm 77 to engage the valve seat 78. Pressurized air passes through a coaxial tube through the center of spring 82 to an aperture 83 in the actuator armature 80, which is on the opposite side of baffle 84 from the spring 82. The air pressure acts against the baffle and spring to bias the diaphragm 77 open via the armature 80 and allow chemical to flow through the valve. This represents only one of several ways a pneumatic actuator operates and the operation of the pneumatic actuator is not an aspect of the present invention. Any of the known methods and apparatus for actuating using pneumatics can be contemplated, and in fact non-pneumatic actuation can be used, such as manual or solenoid actuation. Valve 75 is similarly equipped with valve actuation equipment, not illustrated, similar to 68, 70, 72 and 86.

FIG 2B shows an exploded perspective view of the block diaphragm valve assembly of FIG 2A, this time showing the pneumatic actuator 68a for valve 75. The diaphragm valves' locations, illustrated for one valve as core 88, are bored out of a single monoblock of material, such as ceramics, plastics such as Teflon, or other suitable materials, but preferably is metal, such as electropolished stainless steel. Aperture 12a of second conduit 12 is illustrated to show the diaphragm side connection of the conduits in the valve. Valve seat 78a delineates the valve seat side of the sealing surface of the valve seat 78a and the diaphragm 74a, shown removed from its core location 88. Pneumatic actuator 68a is shown with its pneumatic gas source connection 86a. Conduits 12, 16b and 18 are shown, respectively, emanating from the monoblock of block diaphragm valve assembly 14.

Second block diaphragm valve assembly 20 is similar to first block valve assembly 14 as illustrated in FIG 2A, with conduit 16 in this instance with regard to second block valve assembly 20 corresponding to the structure shown for first conduit 16, conduit 112 corresponding to the structure shown for second conduit 12, and conduit 110 corresponding to the structure shown for third conduit 18, as it relates to first block diaphragm valve assembly.

First low dead space connection 24 is illustrated in FIG 3. Sealing surface 90 of first conduit 16 ends with an annular knife edge 94 depending axially from the sealing surface in the direction of the sealing surface 89 of the conduit 16, which also has an annular knife edge 96 depending axially from its sealing surface. These knife edges 94 and 96 engage an annular sealing gasket 92, which is preferably a relatively soft metal to form a low dead space connection with a superior seal. Compression fitting 100 threadably engages ring 98 to force the respective knife edges into sealing engagement with the annular soft metal gasket 92.

In FIG 1A the diaphragm valves are illustrated with a cresent or meniscus depiction to indicate the arrangement of the diaphragm itself with its diaphragm side and its valve seat side in accordance with the depiction of that orientation in FIG 2A. Therefore, the concavity of the diaphragm valves in FIG 1A represent the valve seat side of the diaphragm valve having a low dead space and minimum wetted surface area and the convex side of the diaphragm valves in FIG 1A represents the diaphragm side of the diaphragm valve which has greater potential dead space and more potential wetted surface area, as described with regard to FIG 2A above.

The present invention provides unique and unexpected improvement over the prior art in low vapor pressure, high purity chemical distribution from a container of the chemical by using a combination of two block diaphragm valve assemblies connected by a low dead space connection wherein the diaphragm valves have their valve seat sides facing one another in the block valve assemblies to provide a minimal wetted surface area for decontamination of the chemical at such times as container changeout or servicing. Clean out using the apparatus of the present invention has demonstrated drydown times of less than one hour where the prior art has taken days. This allows electronic device fabricators to minimize down time for change outs or service and to maximize utilization of the expensive equipment designed to produce electronic devices in fabs easily costing over $1 billion per plant to construct and operate.

The present invention has been set forth with regard to several preferred embodiments, but the full scope of the present invention should be ascertained from the claims below.

## Claims

1. A purgeable container (10) for low vapor pressure, high purity chemicals for a high purity chemical delivery system, comprising:
(a) a container (10) for containing a quantity of said low vapor pressure, high purity chemical having at least two ports (11, 13) capable of receiving or dispensing said low vapor pressure, high purity chemical;
(b) a first block diaphragm valve assembly (14) having first (75) and second (77) diaphragm valves,
(b1) each diaphragm valve having a diaphragm (74a, 74) and having a valve seat (78a, 78) side and a diaphragm side (88),
(b2) wherein the valve seat (78a) side of each diaphragm valve is juxtaposed to the other valve seat (78) side of the other diaphragm valve, and
(b3) each valve seat (78a, 78) side of each diaphragm valve (75, 77) having low vapor pressure, high purity chemical flow communication with a first conduit (16) of said high purity chemical delivery system, and
(b4) said diaphragm side (88) of said second diaphragm valve (77) having flow communication with a second conduit (18) providing access to a source of vacuum, or a source of vent;
(c) a second valve means (114) having flow communication with a third conduit (118) providing access to a source of push gas, a source of vacuum, or a dispense for low vapor pressure, high purity chemical; and
(d) a second (11) of said at least two ports (11,13) having flow communication with said container (10) and providing access to a source of vacuum, or a source of vent to said container (10), or delivering push gas to said container (10);
(e) said second valve means (114) controlling the second port (11) and providing access to the source of vacuum/vent (122) and/or the source of push gas (126) through said third conduit (118), which has a low dead space connector (116); and **characterised in that**
(f) said second valve means not being part of a block valve assembly of more than one valve;
(g) further comprising a third valve (124) through which the container (10) can be supplied with the push gas from the source of push gas (126) through the third conduit (118), the low dead space connector (116), the second valve means (114) and the second part (11);
(h) and a fourth valve (120) through which the vacuum from the source of vacuum (122) can be introduced into the third conduit (118) and through the low dead space connector (116) and through or up to the second valve means (114);
and **in that**
(i) said diaphragm side (88) of said first diaphragm valve (75) having flow communication with a first (13) of said at least two ports (11, 13).

2. The container of Claim. 1 wherein said valve seat (78) side of said second diaphragm valve (77) has flow communication with a conduit (112) for a source of high pressure purge gas that is used to purge residual low volatility chemical from the wetted surface to vent or vacuum via the first port (13).

3. The container of Claim 1 wherein said diaphragm side (88) of said second diaphragm valve (77) has flow communication with the second conduit (18) for the source of vacuum.

4. The container of Claim 1 wherein said diaphragm side (88) of said second diaphragm valve (77) has flow communication with the second conduit (18) for the source of vent.

5. The container of Claim 3 wherein said second valve means (114) has flow communication with a conduit (126) for purge gas.

## Patentansprüche

1. Durchspühlbarer Behälter (10) für hochreine Chemikalien mit niederem Dampfdruck für ein Zuführungssystem für eine hochreine Chemikalie, umfassend:
a) einen Behälter (10), der eine Menge der hochreinen Chemikalie mit niederem Dampfdruck enthält und wenigstens zwei Ports (11, 12) umfasst, die die hochreine Chemikalie mit niederem Dampfdruck erhalten oder abgeben können;
b) eine erste Membranventilblockeinheit (14) mit ersten (75) und zweiten (76) Membranventilen,
b1) wobei jedes Membranventil eine Membran (74a, 74) umfasst und eine Ventilsitzseite (78a, 78) und eine Membranseite (88) hat,
b2) wobei die Ventilsitzseite (78a) jedes Membranventils der anderen Ventilsitzseite (78) des anderen Membranventils gegenüberliegt, und
b3) jede Ventilsitzseite (78, 78a) jedes Membranventils (75, 76) eine Fließverbindung für die hochreine Chemikalie mit niederem Dampfdruck mit einer ersten Leitung (16) des Zuführungssystems für die hochreine Chemikalie hat, und
b4) die Membranseite (88) des zweiten Membranventils (77) eine Fließverbindung mit einer zweiten Leitung (18) hat, die Zugang zu einer Vakuumquelle oder einer Entlüftungsquelle bereitstellt;
c) ein zweites Ventilmittel (114), das in Fließverbindung mit einer dritten Leitung (118) steht, die Zugang zu einer Schubgasquelle, einer Vakuumquelle oder einem Auslass für die hochreine Chemikalie mit niederem Dampfdruck bereitstellt; und
d) einen zweiten (11) der wenigstens zwei Ports (11, 13), der in Fließverbindung mit dem Behälter (10) ist und Zugang zu einer Vakuumquelle oder einer Entlüftungsquelle zu dem Behälter (10) bereitstellt oder Schubgas zu dem Behälter (10) liefert;
e) wobei das zweite Ventilmittel (114) den zweiten Port (11) kontrollieren und Zugang zu der Vakuum-/Entlüftungsquelle (122) und/oder die Schubgasquelle (126) durch die dritte Leitung (118), die einen Verbinder (116) mit kleinem Totraum umfasst, bereitstellt,
**dadurch gekennzeichnet, dass**
f) dieses zweiten Ventilmittel nicht Teil eines Ventilblockeinheit mit mehr als einem Ventil ist,
g) weiterhin umfassend ein drittes Ventil (124), durch das der Behälter (10) mit Schubgas von der Schubgasquelle durch die dritte Leitung (118), den Verbinder (116) mit dem kleinen Totraum, das zweite Ventilmittel (114) und den zweiten Port (11) versorgt werden kann;
h) und ein viertes Ventil (120), durch das Vakuum von der Vakuumquelle (122) in die dritte Leitung (118) und durch den Verbinder (116) mit dem kleinen Totraum und durch oder zu dem zweiten Ventilmittel (114) eingeleitet werden kann;
i) und dass die Membranseite (88) des ersten Membranventils (75) in Fließverbindung mit dem ersten (13) der wenigstens zwei Ports (11, 13) steht.

2. Behälter nach Anspruch 1, wobei die Ventilsitzseite (78) des zweiten Membranventils (77) in Fließverbindung mit einer Leitung (112) für eine Quelle eines Hochdruckspülgases steht, das benutzt wird, um Rückstände schwerflüchtiger Chemikalien von der benetzten Oberflächen über den ersten Port (13) zu der Entlüftung oder dem Vakuum abzuführen.

3. Behälter nach Anspruch 1, wobei die Membranseite (88) des zweiten Mambranventils (77) in Fließverbindung mit der zweiten Leitung (18) für die Vakuumquelle steht.

4. Behälter nach Anspruch 1, wobei die Membranseite (88) des zweiten Mambranventils (77) in Fließverbindung mit der zweiten Leitung (18) für die Entlüftungsquelle steht.

5. Behälter nach Anspruch 3, wobei das zweite Ventilmittel (114) in Fließverbindung mit einer Leitung (116) für das Spülgas steht.

## Revendications

1. Réservoir purgeable (10) pour des produits chimiques de haute pureté à faible pression de vapeur, destiné à un système distributeur de produits chimiques de haute pureté, comprenant :
(a) un réservoir (10) pour contenir une quantité de produit chimique de haute pureté à faible pression de vapeur, présentant au moins deux orifices (11, 13) capables de recevoir ou de distribuer ledit produit chimique de haute pureté à faible pression de vapeur ;
(b) un premier ensemble de vannes de séparation à membrane (14) présentant des première (75) et deuxième (77) vannes à membrane,
(b1) chaque vanne à membrane présentant une membrane (74a, 74) et présentant un côté siège de vanne (78a, 78) et un côté membrane (88),
(b2) dans lequel le côté siège de vanne (78a) de chaque vanne à membrane est juxtaposé à l'autre côté siège de vanne (78) de l'autre vanne à membrane, et
(b3) chaque côté siège de vanne (78a, 78) de chaque vanne à membrane (75, 77) étant en communication fluidique de produit chimique de haute pureté à faible pression de vapeur, avec un premier conduit (16) dudit système distributeur de produit chimique de haute pureté, et
(b4) ledit côté membrane (88) de ladite vanne à membrane (77) étant en communication fluidique avec un deuxième conduit (18) fournissant un accès à une source de vide ou une source d'aération ;
(c) un deuxième moyen de vanne (114) étant en communication fluidique avec un troisième conduit (118) fournissant un accès à une source de gaz de poussée, une source de vide, ou une distribution pour le produit chimique de haute pureté à faible pression de vapeur ; et
(d) un deuxième (11) desdits au moins deux orifices (11, 13) étant en communication fluidique avec ledit réservoir (10) et fournissant un accès à une source de vide, ou une source d'aération audit réservoir (10), ou fournissant du gaz de poussée audit réservoir (10) ;
(e) ledit deuxième moyen de vanne (114) contrôlant le deuxième orifice (11) et fournissant un accès à la source de vide ou d'aération (122) et/ou à la source de gaz de poussée (126) par ledit troisième conduit (118) qui présente un connecteur de petit espace mort (116) ; et **caractérisé en ce que**
(f) ledit deuxième moyen de vanne ne faisant pas partie d'un ensemble de vannes de séparation de plus d'une vanne ;
(g) comprenant en outre une troisième vanne (124) par laquelle le réservoir (10) peut être alimenté en gaz de poussée depuis la source de gaz de poussée (126) par le troisième conduit (118), le connecteur de petit espace mort (116), le deuxième moyen de vanne (114) et la deuxième partie (11) ;
(h) et une quatrième vanne (120) par laquelle le vide provenant de la source de vide (122) peut être introduit dans le troisième conduit (118) et par le connecteur de petit espace mort (116) et par ou jusqu'au deuxième moyen de vanne (114) ;
et **en ce que**
(i) ledit côté membrane (88) de ladite première vanne à membrane (75) étant en communication fluidique avec un premier (13) desdits au moins deux orifices (11, 13).

2. Réservoir selon la revendication 1, dans lequel ledit côté siège de vanne (78) de ladite deuxième vanne à membrane (77) est en communication fluidique avec un conduit (112) pour une source de gaz de purge haute pression qui est utilisée pour purger le produit chimique à faible volatilité résiduelle de la surface mouillée pour l'aération ou le vide via le premier orifice (13).

3. Réservoir selon la revendication 1, dans lequel ledit côté membrane (88) de ladite deuxième vanne à membrane (77) est en communication fluidique avec le deuxième conduit (18) pour la source de vide.

4. Réservoir selon la revendication 1, dans lequel ledit côté membrane (88) de ladite deuxième vanne à membrane (77) est en communication fluidique avec le deuxième conduit (18) pour la source d'aération.

5. Réservoir selon la revendication 3, dans lequel ledit deuxième moyen de vanne (114) est en communication fluidique avec un conduit (126) pour le gaz de purge.
